# EUROPEAN PATENT APPLICATION

(11) **EP 4 699 723 A1**
(43) Date of publication of application: **25.02.2026**
(21) Application number: 24786342.6
(22) Date of filing: 07.08.2024
(51) Int. Cl.: B22D 19/00, H01S 5/024

(54) **PREPARATION PROCESS FOR ALUMINUM-COPPER INTEGRATED DIE-CAST COMPOSITE HEAT SINK FOR LASER CHIP, AND HEAT SINK**

(30) Priority: 03.07.2024 CN 202410881304
(71) Applicant: Trio Metal (GZ) Co., Ltd, Guangzhou, Guangdong 510000 (CN)
(72) Inventor: WANG, Xinyun, Guangzhou, Guangdong 510000 (CN); HAI, Binbin, Guangzhou, Guangdong 510000 (CN); WANG, Yuhuan, Guangzhou, Guangdong 510000 (CN); HUANG, Yajun, Guangzhou, Guangdong 510000 (CN)
(74) Representative: Hertin und Partner Rechts- und Patentanwälte PartG mbB
(86) International application number: PCT/CN2024/110333
(87) International publication number: WO 2026/007190

(57) **Abstract**

The present invention discloses a composite radiator manufactured by an aluminum-copper integrated die-casting process for a laser chip. In the process, a copper heat dissipation assembly, after being completely manufactured, is stably provided in an anti-gravity cavity mold, and is die-cast with an aluminum material to form a copper-aluminum composite, which is subjected to (T4+T6) heat treatments to be prepared into a composite blank, so as to improve overall use performance of the radiator, such as hardness and size stability, and enable the radiator to maintain high dimensional stability, thermal shock resistance and high temperature and humidity resistance in an extreme environment of -40-280 °C; single T2 copper heat dissipation and heat exchange flow paths are formed, an advanced coolant is used, and in combination with a structure design of a cooling module, an totally-enclosed cooling circulation system is formed, the problems of water electrolysis and microorganism generation of the coolant in use and oxidation or corrosion of the flow paths are solved; an integrated laser pump source structure with a concise structure, efficient cooling, stable dimension, and easy post processing is manufactured; and high-reliability and low-cost requirements are met, and competitiveness of products is enhanced.

## Description

### CROSS-REFERENCE TO RELATED APPLICATION

The present invention claims the priority to the Chinese patent application with the filing No. 2024108813047 filed on July 3, 2024 with the Chinese Patent Office, and entitled "METHOD OF MANUFACTURING ALUMINUM-COPPER INTEGRATED DIE-CASTING COMPOSITE RADIATOR FOR LASER CHIP AND RADIATOR", the contents of which are incorporated herein by reference in entirety.

### TECHNICAL FIELD

The present invention relates to the technical field of semiconductor chip manufacture, and specifically to a method of manufacturing an aluminum-copper integrated die-casting composite radiator for a laser chip and a radiator.

### BACKGROUND ART

The laser chip is a semiconductor chip device configured to generate laser beam. It is a core component of a laser diode, and is a special chip for generating coherent light beam by exciting atoms or molecules in a semiconductor material.

The working principle of the laser chip is based on stimulated radiation, in which the laser diode makes electrons transition to a low energy level state by injecting electrons and positive electrons into a semiconductor material, and then generates laser light by stimulated radiation. The laser beam is generally monochromatic and coherent, and has high energy and a narrow spectrum width. The laser chip is widely applied, including: optical communications (configured as laser transmitter and receivers in an optical fiber communication system), laser printers (configured for laser output in printers), medical devices (configured as medical devices for laser treatment, laser surgery, etc.), distance measuring instrument (configured as measuring devices such as laser range finders and laser radars), optical sensors (configured for various optical sensor applications, such as photoelectric switches), and cutting and welding (configured for material cutting, welding and processing). The small size, high efficiency and tunability of the laser chip make it indispensable to modern scientific and industrial applications.

The laser chip generates a large amount of heat when operating, and if heat cannot be effectively dissipated, a temperature of the chip will be increased, thereby affecting performance and stability of a laser device. Therefore, heat dissipation is required during operation of the laser chip, so as to ensure that the chip can maintain a low temperature while operating.

Existing radiators for the laser chip are generally copper-based or aluminum-based radiators, which conduct heat away from the chip using good heat conducting property of metals, and take the heat away through cooling flow channels of heat sinks.

However, the inventors find that these radiators still have following drawbacks.
1. Pure aluminum or pure copper material is used, while the pure aluminum has a heat conduction coefficient of 205 W/m·K-235 W/m·K and thus has low heat transfer efficiency and poor heat dissipation effect; and the heat conduction coefficient of copper is 401 W/(m·K), but a yield ratio of the pure copper is less than 50%, and a design with copper material without a heat dissipation area causes material waste, thus an effective utilization rate is low, and costs are high.
2. Overall design of a single material restricts that a whole product can only be processed by machining, with a complex structure, a long processing time, high processing costs, vulnerability to cracking and deformation, low yield of finished products, and a short service life.
3. Heat conduction paths are restricted: the heat conduction paths in the design of the radiator are intersected, which causes flow of a coolant to be blocked and low or uneven heat conduction efficiency, thereby affecting an overall heat dissipation effect.
4. A cooling system is made of different materials: the flow paths of the radiator and a cooling module are made of a plurality of materials, which form electrochemical reactions when being used, thus causing electrolytic corrosion of the materials, and increasing maintenance costs and reducing service life.

### SUMMARY

In order to solve the problems of unreasonable design, material waste, high costs, vulnerability to cracking and deformation due to mere mechanical technology, short service life, and poor heat dissipation effect of the radiator used in the existing method of manufacturing the semiconductor laser chip, the present invention provides a method of manufacturing an aluminum-copper integrated die-casting composite radiator for a laser chip, which is more reasonable in design, more cost-saving, and not vulnerable to cracking, and has a long service life and good heat dissipation effect, and a radiator.

Technical solutions of the present invention are as follows.

The present invention discloses a method of manufacturing an aluminum-copper integrated die-casting composite radiator for a laser chip, including following steps:
in S1, manufacturing an inner core of a radiator including inner-core bodies and inner-core fittings:
in S11, placing a copper rod into a mold of the inner-core bodies, applying a pulling force to form several inner-core bodies matching a shape of the mold of the inner-core bodies, further milling the inner-core bodies, thus completing manufacturing of the inner-core bodies made of pure copper;
in S12, welding the several inner-core bodies that have been manufactured and the inner-core fittings into one piece;
in S13, subjecting the inner-core bodies and the inner-core fittings welded into one piece to copper polishing, cleaning, nickel plating, and drying treatments, thus completing manufacturing of the inner core of the radiator including the inner-core bodies and the inner-core fittings; and
in S14, filling foundry sand into the inner core;
in S2, manufacturing an outer shell of the radiator, and forming a copper-aluminum composite blank with the inner core and the outer shell being integrated:
in S21, preparing an aluminum liquid;
in S22, placing the manufactured inner core into an anti-gravity cavity mold, filling the prepared aluminum liquid into the cavity mold, performing a die casting treatment to form a copper-aluminum-part composite blank with the aluminum-made outer shell wrapping the copper-made inner-core bodies and the inner-core fittings, and demolding and naturally cooling to 20-35 °C;
in S23, trimming the outer shell, to remove a material strip and a slag package, and purging and removing the foundry sand in the inner core of the radiator;
in S24, performing T4+T6 heat treatments on the outer shell having undergone the die casting treatment;
in S25, subjecting the outer shell having undergone the heat treatments to CNC roughing; and
in S26, cleaning and drying the integrated copper-aluminum-part composite blank having been roughed.

Optionally, performing T4+T6 heat treatments on the outer shell having undergone the die casting treatment in the step S24 specifically includes following substeps:
S241, solutionizing treatment: heating the outer shell to a solutionizing temperature to make solute atoms in the outer shell to be fused into solvent lattice, wherein the solutionizing treatment is performed at a temperature of 470-540 °C for a time of 2-3 h;
S242, rapid cooling treatment: subjecting the outer shell having undergone the solutionizing treatment to a water-quenching treatment, to rapidly cool the outer shell to 20-35 °C;
S243, aging treatment: continuously heating the rapidly cooled outer shell at a temperature of 120-200 °C for a time of 2-3 h; and
S244, natural cooling treatment: leaving the outer shell having undergone the aging treatment to stand at 20-35 °C.

Optionally, preparing an aluminum liquid in the step S21 specifically includes following substeps:
S211, heating and stirring an aluminum material, and adding a grain refiner into the aluminum material in a solution state to form molten aluminum; and
S212, further performing a degassing treatment on the molten aluminum added with the grain refiner to render the prepared aluminum liquid.

Optionally, subjecting the inner-core bodies and the inner-core fittings welded into one piece to copper polishing, cleaning, nickel plating, and drying treatments in the step S13 specifically includes: performing the copper polishing to remove an oxide layer, cleaning with an ultrasonic degreasing agent, rinsing with pure water, then performing surface nickel plating treatment, next performing wind-shear dewatering, and then performing tunnel drying, wherein a drying temperature is 100 °C at the highest; and the cleaning and drying the integrated copper-aluminum composite blank in the step S26 specifically includes: cleaning with an ultrasonic degreasing agent, then rinsing with pure water, next performing wind-shear dewatering, and then performing tunnel drying, wherein a drying temperature is 100 °C at the highest.

Optionally, for milling the inner-core bodies in the step S11, the inner-core bodies are milled specifically using a CNC machining process; and subjecting the outer shell having undergone the heat treatments to CNC roughing in the step S25 specifically is cutting the outer shell.

Optionally, in preparing the aluminum liquid in the step S21, a weight ratio of the grain refiner to the aluminum liquid is 0.2:100.

Optionally, in die-casting solidification shrinkage in the step S22, the die casting treatment is performed at a temperature of 500-800 °C and a pressure of 80-120 MPa for a time of 150-220 s.

Optionally, for the pulling force applied in the step S11, a value of the pulling force is 15000-22000 N.

The present invention further discloses an aluminum-copper integrated die-casting composite radiator for a laser chip, wherein the aluminum-copper integrated die-casting composite radiator for a laser chip is manufactured by the above method of manufacturing an aluminum-copper integrated die-casting composite radiator for a laser chip, and includes: several inner-core bodies, inner-core fittings and an outer shell, wherein the inner core fittings include several connectors and several pipelines, one of the connectors is fixed to an end of a first one of the inner-core bodies by welding, another one of the connectors is fixed to an end of a last one of the inner-core bodies by welding, the pipelines connect the several inner-core bodies end to end, and the outer shell wraps the inner-core bodies and the inner-core fittings that are welded into one piece. The inner-core bodies are made of a pure copper material, and the outer shell is made of a die-casting aluminum material.

Optionally, the inner-core bodies each include an inner tube provided with several heat dissipation slots on an inner wall and an outer wall provided with several slot strips, a diameter of the inner tube is the same as an internal diameter of the connectors and a diameter of the pipelines, and a cross section of the heat dissipation slots is in a peak-tooth shape.

The present invention has following beneficial effects.
(1) In the manufacturing process, first, the inner core of the radiator with the copper-made inner-core bodies and the inner-core fittings is manufactured, then in the method of manufacturing the aluminum-made outer shell, the inner core is stably provided in the outer shell by means of die casting and T4+T6 heat treatments, the inner core with the copper-made inner-core bodies and the aluminum-made outer shell are bonded to form the copper-aluminum-part composite, which has better strength and wear resistance, improves overall use performance of the radiator, and enables the radiator to maintain high dimensional stability, thermal shock resistance and high temperature and humidity resistance in the extreme environment of -40-280 °C; moreover, the radiator is not simply machined, so that the radiator is not vulnerable to cracking or deformation; besides, the surfaces of the inner core and the outer shell of the radiator are respectively subjected to surface finishing, thus ensuring the heat dissipation effect of the radiator; and
(2) The inner-core bodies of the radiator are made of the pure copper material, and the outer shell of the radiator is made of the die-casting aluminum material, so that areas are dedicated for special uses, material waste is avoided, and the costs are saved; the design of the heat dissipation slots of the inner-core bodies increases the heat dissipation area, and improves the heat dissipation efficiency; the design of the slot strips on the outer walls of the inner-core bodies ensures that the connection between the inner core and the outer shell of the radiator is more stable, the structural size stability is strong, the service life is prolonged, and the maintenance cost is reduced

### BRIEF DESCRIPTION OF DRAWINGS

FIG. 1 is a flowchart of a method of manufacturing an aluminum-copper integrated die-casting composite radiator for a laser chip in the present invention;
FIG. 2 is a perspective structural schematic view of an internal structure of the aluminum-copper integrated die-casting composite radiator for a laser chip in the present invention;
FIG. 3 is a structural schematic view of an inner core of the aluminum-copper integrated die-casting composite radiator for a laser chip in the present invention;
FIG. 4 is a sectional structural schematic view of an inner-core body of the aluminum-copper integrated die-casting composite radiator for a laser chip in the present invention; and
FIG. 5 is a flowchart of a method of manufacturing a radiator in the present invention.

Reference signs: 1. inner-core body, 2. inner-core fitting, 3. outer shell, 4. inner tube, 5. outer wall, 6. heat dissipation slot, 7. slot strip, 8. connector, 9. pipeline.

### DETAILED DESCRIPTION OF EMBODIMENTS

In order to further clarify technical problems to be solved, technical solutions and beneficial effects of the present invention, the present invention is further described in detail below in conjunction with the drawings and embodiments. It should be understood that the embodiments described herein are merely used to explain the present invention, rather than being intended to limit the present invention.

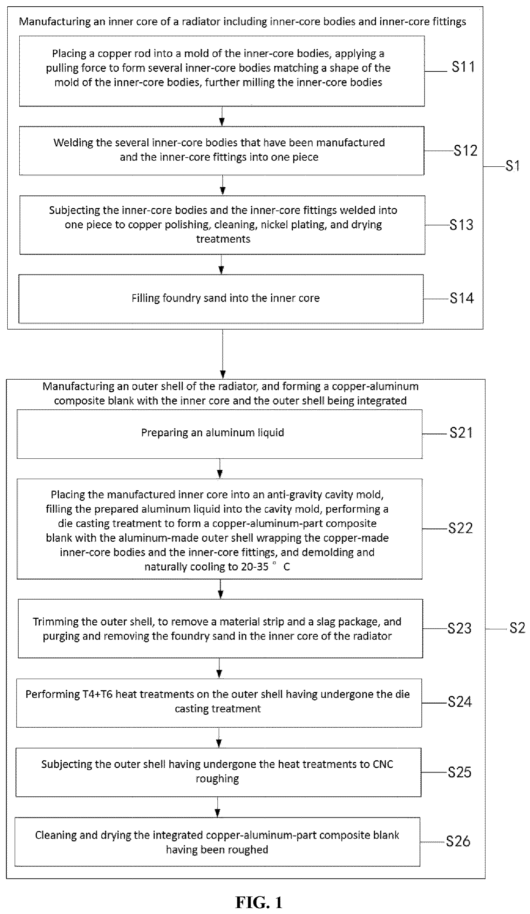

Example 1: Referring to FIG. 1, a method of manufacturing an aluminum-copper integrated die-casting composite radiator for a laser chip included following steps.

In S1, an inner core of a radiator including inner-core bodies 1 and inner-core fittings 2 was manufactured.

In S11, a 99.9% pure copper rod was placed into a mold of the inner-core bodies 1, wherein the 99% pure copper rod is grade T2 copper, and a pulling force of a value of 20000 N was applied, to form several inner-core bodies 1 matching a shape of the mold of the inner-core bodies 1. Further, the inner-core bodies 1 were milled, that is, according to a required length of the inner-core bodies 1, an elongated structure via draw forming was cut into several inner-core bodies 1 with a preset length, thus completing manufacturing of the pure copper-made inner-core bodies 1.

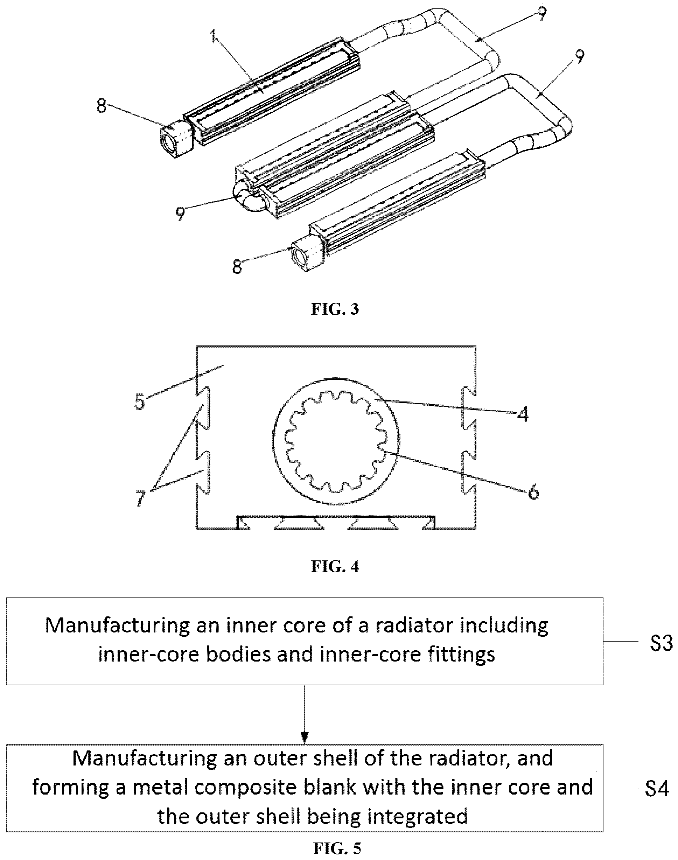

In FIG. 4, each inner-core body 1 includes an inner tube 4 provided with heat dissipation slots 6 and an outer wall provided with slot strips 7; therefore, the mold of the inner-core bodies 1 is also provided therein with first protrusions matching shapes of the heat dissipation slots 6 and second protrusions matching shapes of the slot strips 7. A drawing process used is simple, and conveniently and quickly forms required shapes. Moreover, taking the inner-core body 1 of pure copper, whose heat conduction coefficient is 401 W/(m•K), as a core component will not cause material waste and reduce production costs.

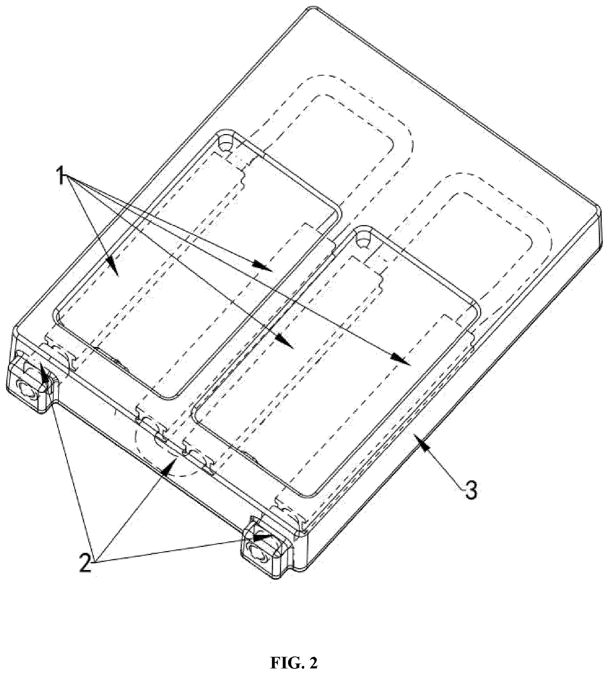

In S12, referring to FIG. 2 and FIG. 3, the several inner-core bodies 1 that had been manufactured and the inner-core fittings 2 were welded into one piece. The inner-core fittings 2 include connectors 8 and pipelines 9. The radiator is used for flow of a coolant. The pure-copper inner-core bodies 1 can also be referred to as grade T2 copper-made heat dissipation and heat exchange flow paths. The coolant may be an advanced coolant. Thus, the radiator has liquid inlet and outlet, wherein a first connector 8 can serve as a liquid inlet, and the first connector 8 is fixed with an end of a first inner-core body 1 by welding; and a second connector 8 serves as a liquid outlet, and the second connector 8 is fixed with an end of a last inner-core body 1 by welding. Two inner-core bodies 1 are provided between the first inner-core body 1 and the last inner-core body 1, the inner-core bodies 1 communicate with each other through the pipelines 9, and the pipelines 9 are also fixed on the inner-core bodies 1 by welding. The inner core on the whole is of a multi-bend structure, which further increases a heat dissipation area and improves heat dissipation efficiency. The structurally solid inner core is a reliable cooling circulation system, which can also be referred to as a totally-enclosed cooling circulation system, and through cooperation with the advanced coolant, solves the problems of water electrolysis and microorganism generation of the coolant in an operating condition and oxidation or corrosion of the flow paths in the related art. The radiator of the present invention can be free of maintenance for more than 10 years.

In S13, the inner-core bodies 1 and the inner-core fittings 2 welded into one piece were subjected to copper polishing, cleaning, nickel plating, and drying treatments. First, the copper polishing treatment was performed to remove a surface oxide layer; cleaning with an ultrasonic degreasing agent is performed, which could efficiently remove greasy dirt and impurities on a surface of the inner core, and ensure cleanliness of the surface of the inner core; then rinsing with pure water was performed; next surface nickel plating treatment was performed, which could prevent oxidation and reduce the risk of mutual dissolution of copper and aluminum at a high temperature; then wind-shear dewatering was performed, which could quickly remove moisture from a surface of a workpiece, reduce water stain residues, and facilitate progress of subsequent drying and coating processes; then tunnel drying was performed, wherein a drying temperature was 100 °C at the highest and could be adjusted according to practical requirements, so that the moisture on the surface of the inner core could be quickly evaporated completely to ensure the surface of the inner core to be dry and avoid problems caused by moisture residues. The rinsing with pure water could completely clean away residues of the cleaning agent and other impurities, thus avoiding adverse effects on subsequent processes. The manufacturing of the inner core of the radiator including the inner-core bodies 1 and the inner-core fittings 2 was completed.

In S14, foundry sand was filled into the inner core, so that a cavity structure could withstand a casting pressure of 100 Mpa.

In S2, an outer shell 3 of the radiator was manufactured, and a copper-aluminum composite blank was formed with the inner core and the outer shell 3 being integrated.

In S21, an aluminum liquid was prepared, specifically as follows:
in S211, an aluminum material was heated and stirred, wherein type of the aluminum material was A356, a heating temperature was 700-750 °C, and a grain refiner was added into the aluminum material in a solution state to form molten aluminum; and
in S212, a degassing treatment was further performed on the molten aluminum added with the grain refiner to render the prepared aluminum liquid meeting requirements.

It is worth noting that a weight ratio of the grain refiner to the aluminum liquid is 0.2:100. The grain refiner mainly functions to improve microstructures of a casting, refine grains, improve mechanical properties and surface quality of the casting, and reduce defects such as shrinkage holes and gas holes. A main effect of the degassing treatment is to remove gases in the aluminum liquid, reduce generation of the shrinkage holes and gas holes, and improve density and mechanical performance of the casting.

In S22, the manufactured inner core was placed into an anti-gravity cavity mold, the prepared aluminum liquid was filled into the cavity mold, and a die casting treatment was performed to form a copper-aluminum-part composite blank with the aluminum-made outer shell 3 wrapping the copper-made inner-core bodies 1 and the inner-core fittings 2. The die casting treatment was performed at a temperature of 750 °C and a pressure of 100 MPa for a time of 180 s.

It is worth noting that a shape of an inner wall of the cavity mold matches a shape of the inner core and a shape of the outer shell, and the aluminum liquid fills gaps of the cavity mold to wrap the inner core.

In addition, the copper-aluminum-part composite blank with the aluminum-made outer shell wrapping the copper-made inner-core bodies and the inner-core fittings, after being formed, can also be demolded and naturally cooled to 20-35 °C.

In S23, the outer shell 3 was trimmed, to remove a material strip and a slag package, that is, the material strip and the slag package were removed by a saw blade cutter. The material strip is tailings formed by a material well in a mold in a die casting process, and in order to ensure parts to be completely filled in a mold, the material well is provided in a position where it is not easy to fill according to a product shape, so that this region is filled with more aluminum liquid so as to achieve a purpose of complete filling. The slag package refers to residues formed in a material package at a feeding port of a mold. The material package is a device for supplying molten metal to a mold in a die casting process, is located in a feeding system of a die-casting machine, and feeds the molten metal into a mold cavity by being connected to the die-casting mold. Moreover, the foundry sand in the inner core of the radiator was purged and removed, that is, the foundry sand in the inner core of the radiator was purged and removed by a high-pressure air rifle.

In S24, T4+T6 heat treatments were performed on the outer shell 3 having undergone the die casting treatment, specifically including following steps:
S241, solutionizing treatment: the outer shell 3 was heated to a solutionizing temperature to make solute atoms in the outer shell 3 to be fused into solvent lattice. The solute refers to a substance dissolved in an aluminum solvent, and the solvent lattice refers to a crystal structure of a main component in the outer shell 3, wherein atoms are arranged in order to form a lattice structure. The solutionizing treatment was performed at a temperature of 520 °C for a time of 3 h. This process can improve uniformity and hardness of the outer shell 3, and meanwhile adjust mechanical and chemical properties of alloy;
S242, rapid cooling treatment: the outer shell 3 having undergone the solutionizing treatment was subjected to a water-quenching treatment, to rapidly cool the outer shell 3 to 20-35 °C, so as to prevent precipitation of the solute from a solid solution as far as possible;
S243, aging treatment: the rapidly cooled outer shell 3 was continuously heated at a temperature of 180 °C for a time of 3 h, so as to enhance hardness and strength of the alloy; and
S244, natural cooling treatment: the outer shell 3 having undergone the aging treatment was left to stand at 20-35 °C, so that the solute inside the solid solution of the outer shell 3 was gradually diffused and precipitated to form a desired strengthening phase, thereby further improving the hardness and strength of the outer shell 3.

In the above T4+T6 heat treatments, the strengthening phase is formed by precipitating the solid solute in the solid solution from the alloy, so that the hardness and strength of the alloy are improved, and the hardness of the outer shell 3 can be improved to 95 HV or above. It is worth noting that, when the laser chip is in some special application scenarios, for example, in the fields of aviation and aerospace, automotive electronics, industrial testing and so on, and an ambient temperature is -40-280 °C, the radiators in the related art are likely to crack, causing that the radiators cannot work normally, while the radiator in the present invention can maintain high dimensional stability, thermal shock resistance and high temperature and humidity resistance in an extreme environment of -40-280 °C.

In S25, the outer shell 3 having undergone the heat treatments was subjected to CNC roughing, that is, the outer shell 3 having undergone the heat treatments was subjected to CNC cutting by utilizing process positioning hole building reference, so as to process out an XYZ reference, and facilitate fine positioning and fine processing in post processes.

In S26, the copper-aluminum composite blank with the inner core was cleaned and dried. First, cleaning with an ultrasonic degreasing agent was performed, which could efficiently remove greasy dirt and impurities on a surface of the outer shell 3, and ensure cleanliness of the surface of the outer shell 3; then rinsing with pure water was performed; next wind-shear dewatering was performed, which could quickly remove moisture from a surface of a workpiece, reduce water stain residues, and facilitate progress of subsequent drying and coating processes; and finally tunnel drying was performed, wherein a drying temperature was 100 °C at the highest, which can quickly evaporate the moisture on the surface of the outer shell 3 completely to ensure the surface of the outer shell 3 to be dry and avoid problems caused by moisture residues. The rinsing with pure water could completely clean away residues of the cleaning agent and other impurities, thus avoiding adverse effects on subsequent processes.

Optionally, milling the inner-core bodies 1 in the step S11 is milling the inner-core bodies 1 by a CNC machining process; in the step S25, the outer shell having undergone the heat treatments is subjected to the CNC roughing, so as to finely process the surface, and ensure accuracy of sizes and shapes of the inner-core bodies 1 and the outer shell 3. The CNC machining proceeds automatically, thus greatly improving the production efficiency and reducing the time and costs of manual operation. The CNC machining can maintain stable machining quality in the production, and reduce errors caused by human factors.

Example 2: a method of manufacturing an aluminum-copper integrated die-casting composite radiator for a laser chip, including following steps.

In S1, an inner core of a radiator including inner-core bodies 1 and inner-core fittings 2 was manufactured.

In S11, a 99.9% pure copper rod was placed into a mold of the inner-core bodies 1, and a pulling force of a value of 15000 N was applied, to form several inner-core bodies 1 matching a shape of the mold of the inner-core bodies 1. Further, the inner-core bodies 1 were milled, that is, according to a required length of the inner-core bodies 1, an elongated structure via draw forming was cut into several inner-core bodies 1 with a preset length, thus completing manufacturing of the pure copper-made inner-core bodies 1.

In FIG. 4, each inner-core body 1 includes an inner tube 4 provided with heat dissipation slots 6 and an outer wall 5 provided with slot strips 7; therefore, the mold of the inner-core bodies 1 is also provided therein with first protrusions matching shapes of the heat dissipation slots 6 and second protrusions matching shapes of the slot strips 7. A drawing process used is simple, and conveniently and quickly forms required shapes. Moreover, taking the inner-core body 1 of pure copper, whose heat conduction coefficient is 401 W/(m•K), as a core component will not cause material waste and reduce production costs.

In S12, referring to FIG. 2 and FIG. 3, the several inner-core bodies 1 that had been manufactured and the inner-core fittings 2 were welded into one piece. The inner-core fittings 2 include connectors 8 and pipelines 9. The radiator is used for flow of a coolant, and the radiator thus has liquid inlet and outlet, wherein a first connector 8 can serve as a liquid inlet, and the first connector 8 is fixed with an end of a first inner-core body 1 by welding; and a second connector 8 serves as a liquid outlet, and the second connector 8 is fixed with an end of a last inner-core body 1 by welding. Two inner-core bodies 1 are provided between the first inner-core body 1 and the last inner-core body 1, the inner-core bodies 1 communicate with each other through the pipelines 9, and the pipelines 9 are also fixed on the inner-core bodies 1 by welding. The inner core on the whole is of a multi-bend structure, which further increases a heat dissipation area and improves heat dissipation efficiency.

In S13, the inner-core bodies 1 and the inner-core fittings 2 that were welded into one piece were subjected to copper polishing, cleaning, nickel plating, and drying treatments. First, the copper polishing treatment was performed to remove a surface oxide layer; cleaning with an ultrasonic degreasing agent was performed, which could efficiently remove greasy dirt and impurities on a surface of the inner core, and ensure cleanliness of the surface of the inner core; then rinsing with pure water was performed; next surface nickel plating treatment was performed, which could prevent oxidation and reduce the risk of mutual dissolution of copper and aluminum at a high temperature; then wind-shear dewatering was performed, which could quickly remove moisture from a surface of a workpiece, reduce water stain residues, and facilitate progress of subsequent drying and coating processes; then tunnel drying was performed, wherein a drying temperature was 100 °C at the highest and could be adjusted according to practical requirements, so that the moisture on the surface of the inner core could be quickly evaporated completely to ensure the surface of the inner core to be dry and avoid problems caused by moisture residues. The rinsing with pure water could completely clean away residues of the cleaning agent and other impurities, thus avoiding adverse effects on subsequent processes. The manufacturing of the inner core of the radiator including the inner-core bodies 1 and the inner-core fittings 2 was completed.

In S14, foundry sand was filled into the inner core, so that a cavity structure could withstand a casting pressure of 100 Mpa.

In S2, an outer shell 3 of the radiator was manufactured, and a copper-aluminum composite blank was formed with the inner core and the outer shell 3 being integrated.

In S21, an aluminum liquid was prepared, specifically as follows:
in S211, an aluminum material was heated and stirred, and a grain refiner was added into the aluminum material in a solution state to form molten aluminum; and
in S212, a degassing treatment was further performed on the molten aluminum added with the grain refiner to render the prepared aluminum liquid meeting requirements.

It is worth noting that a weight ratio of the grain refiner to the aluminum liquid is 0.2: 100. The grain refiner mainly functions to improve microstructures of a casting, refine grains, improve mechanical properties and surface quality of the casting, and reduce defects such as shrinkage holes and gas holes. A main effect of the degassing treatment is to remove gases in the aluminum liquid, reduce generation of the shrinkage holes and gas holes, and improve density and mechanical performance of the casting.

In S22, the inner core was placed into an anti-gravity cavity mold, the prepared aluminum liquid was filled into the cavity mold, and a die casting treatment was performed to form a copper-aluminum-part composite blank with the aluminum-made outer shell 3 wrapping the copper-made inner-core bodies 1 and the inner-core fittings 2. The die casting treatment was performed at a temperature of 800 °C and a pressure of 120 MPa for a time of 220 s.

In S23, the outer shell 3 was trimmed to remove a material strip and a slag package, that is, the material strip and the slag package were removed by a saw blade cutter. The material strip refers to a protruding portion formed along an edge of a part or a remaining material on the edge during die casting. The slag package refers to residue or small piece of material on a surface or an edge of a part formed during die casting, which is generally caused by non-uniform flow of material in a filling process or a contact surface of a mold having an angle during casting. Moreover, the foundry sand in the inner core of the radiator was purged and removed, that is, the foundry sand in the inner core of the radiator was purged and removed by a high-pressure air rifle.

In S24, T4+T6 heat treatments were performed on the outer shell 3 having undergone the die casting, specifically including following steps:
S241, solutionizing treatment: the outer shell 3 was heated to a solutionizing temperature to make solute atoms in the outer shell 3 to be fused into solvent lattice. The solute refers to a substance dissolved in an aluminum solvent, and the solvent lattice refers to a crystal structure of a main component in the outer shell, wherein atoms are arranged in order to form a lattice structure. The solutionizing was performed at a temperature of 540 °C for a time of 3 h. This process can improve uniformity and hardness of the outer shell, and meanwhile adjust mechanical and chemical properties of alloy;
S242, rapid cooling treatment: the outer shell 3 having undergone the solutionizing treatment was subjected to a water-quenching treatment, to rapidly cool the outer shell to 20-35 °C, so as to prevent precipitation of the solute from a solid solution as far as possible;
S243, aging treatment: the rapidly cooled outer shell 3 was continuously heated at a temperature of 200 °C for a time of 3 h, so as to enhance hardness and strength of the alloy; and
S244, natural cooling treatment: the outer shell 3 having undergone the aging treatment was left to stand at 20-35 °C, so that the solute inside the solid solution of the outer shell 3 was gradually diffused and precipitated to form a desired strengthening phase, thereby further improving the hardness and strength of the outer shell 3.

The inner core with the copper-made inner-core bodies and the aluminum-made outer shell are bonded to form a copper-aluminum-part composite, which is a composite blank, with better strength and wear resistance. In the above T4+T6 heat treatments, the strengthening phase is formed by precipitating solid solute in the solid solution from the alloy, so that the hardness and strength of the alloy are improved, and the hardness of the outer shell 3 can be improved to 95 HV or above. It is worth noting that, when the laser chip is in some special application scenarios, for example, in the fields of aviation and aerospace, automotive electronics, industrial testing and so on, and an ambient temperature is -40-280 °C, the radiators in the related art are likely to crack, causing that the radiators cannot work normally, while the radiator in the present invention can maintain high dimensional stability, thermal shock resistance and high temperature and humidity resistance in an extreme environment of -40-280 °C.

In S25, the blank having undergone the heat treatments was subjected to CNC cutting by utilizing process positioning hole building reference, so as to process out an XYZ reference, and facilitate fine positioning and fine processing in post processes.

In S26, the integral radiator with the inner core was cleaned and dried. First, cleaning with an ultrasonic degreasing agent was performed, which could efficiently remove greasy dirt and impurities on a surface of the outer shell 3, and ensure cleanliness of the surface of the outer shell 3; then rinsing with pure water was performed; next wind-shear dewatering was performed, which could quickly remove moisture from a surface of a workpiece, reduce water stain residues, and facilitate progress of subsequent drying and coating processes; and finally tunnel drying was performed, wherein a drying temperature was 100 °C at the highest, which can quickly evaporate the moisture on the surface of the outer shell 3 completely to ensure the surface of the outer shell 3 to be dry and avoid problems caused by moisture residues. The rinsing with pure water could completely clean away residues of the cleaning agent and other impurities, thus avoiding adverse effects on subsequent processes.

Optionally, milling the inner-core bodies 1 in the step S11 is milling the inner-core bodies 1 by CNC machining; in the step S25, the outer shell having undergone the heat treatments is subjected to the CNC roughing, so as to finely process the surface, and ensure accuracy of sizes and shapes of the inner-core bodies 1 and the outer shell 3. The CNC machining proceeds automatically, thus greatly improving the production efficiency and reducing the time and costs of manual operation. The CNC machining can maintain stable machining quality in the production, and reduce errors caused by human factors.

Example 3: Referring to FIG. 2 to FIG. 4, the present invention further discloses an aluminum-copper integrated die-casting composite radiator for a laser chip, which is manufactured by the above method of manufacturing an aluminum-copper integrated die-casting composite radiator for a laser chip, including: four inner-core bodies 1, inner-core fittings 2 and an outer shell 3, wherein the inner core fittings 2 include two connectors 8 and three pipelines 9, one connector 8 is fixed to an end of a first inner-core body 1 by welding, the other connector 8 is fixed to an end of a last inner-core body 1 by welding, the pipelines 9 connect the several inner-core bodies 1 end to end, and the outer shell 3 wraps the inner-core bodies 1 and the inner-core fittings 2 that are welded into one piece. The inner core of the present radiator is used for flow of a coolant, thus, the radiator had liquid inlet and outlet, wherein a first connector 8 can serve as a liquid inlet, and a second connector 8 serves as a liquid outlet. Two inner-core bodies 1 are provided between the first inner-core body 1 and the last inner-core body 1, the inner-core bodies 1 communicate with each other through the pipelines 9, and the pipelines 9 are also fixed on the inner-core bodies 1 by welding. The inner core on the whole is of a multi-bend structure, which further increases a heat dissipation area and improves the heat dissipation efficiency. The inner-core bodies 1 are made of a pure copper material, and the outer shell 3 is made of a die-casting aluminum material, that is, only a core for the coolant to flow is made of a pure copper material, and the outer shell 3, configured to protect the inner core, is made of the die-casting aluminum material, which design is reasonable, will not cause material waste, has a high utilization rate, and reduces costs.

In the above, the inner-core bodies are bonded by any one of welding bonding, mechanical bonding, metallurgical bonding or other types of bonding. Definitely, the inner-core bodies are bonded by, but not limited to, welding bonding, mechanical bonding, metallurgical bonding or other types of bonding.

Optionally, a diameter of the inner tube 4 is the same as an internal diameter of the connectors 8 and a diameter of the pipelines 9, thus the coolant is ensured to flow in the inner core of the radiator, and leakage of the coolant is prevented.

Optionally, each inner-core body 1 included an inner tube 4 and an outer wall 5, an inner wall of the inner tube 4 is provided with several heat dissipation slots 6, a cross section of the heat dissipation slots 6 is in a peak-tooth shape, and the heat dissipation slots 6 in the peak-tooth shape further increases the heat dissipation area and dissipates heat during the operation of the laser chip, so as to ensure that the chip can maintain a relatively low temperature when operating; the outer wall 5 is provided with several slot strips 7, and the slot strips 7 are designed for a purpose that when the inner core and the outer shell 3 are die-casted into one piece, that is, the outer wall is of an upside-down structure, the inner core and the outer shell 3 are connected more tightly. In particular, when the laser chip is in some special application scenarios, for example, in the fields of aviation and aerospace, automotive electronics, industrial testing and so on, and an ambient temperature is -40-280 °C, the radiators in the related art are likely to crack, causing that the radiators cannot work normally. The design of the slot strips 7 enables metal structures, even if being deformed in extreme environments, to be buckled with each other, thus ensuring that the inner core is stable in the outer shell 3 and is not likely to crack.

Example 4: Referring to FIG. 2 to FIG. 4, the present invention further discloses a radiator, including several inner-core bodies 1, inner-core fittings 2 and an outer shell 3, wherein the inner-core fittings 2 include several connectors 8 and several pipelines 9, wherein one connector 8 is fixed to an end of a first inner-core body 1 by welding, another connector 8 is fixed to an end of a last inner-core body 1 by welding, the pipelines 9 connect the plurality of inner-core bodies 1 end to end, and the outer shell 3 wraps the inner-core bodies 1 and the inner-core fittings 2 that are welded into one piece.

In the above, the number of the several inner-core bodies 1 may be four, five or six, and the number of the inner-core bodies 1 is not particularly limited in the present embodiment.

The inner-core bodies 1 of the radiator are used for the coolant to flow, and thus the radiator has liquid inlet and outlet. The several connectors 8 may include a first connector 8 and a second connector, wherein the first connector 8 can serve as a liquid inlet and the second connector 8 can serve as a liquid outlet, the first connector 8 is fixed to an end of the first inner-core body 1 by welding, and the second connector 8 is fixed to an end of the last inner-core body 1 by welding, two inner-core bodies 1 may be provided between the first inner-core body 1 and the last inner-core body 1, and the inner-core bodies 1 communicate with each other through the pipelines 9.

It is worth noting that, the first connector 8 can also serve as the liquid outlet, and the second connector 8 can also serve as the liquid inlet, which is not specifically limited in the present embodiment.

In the present embodiment, by means of the inner-core bodies 1 connected end to end, the flow of the coolant is prevented from being blocked to cause low or non-uniform heat conduction efficiency, thereby improving the overall heat dissipation effect.

Optionally, the radiator provided in the present example is at least applied to the following fields: laser chips, data centers, high-performance computers, artificial intelligence, and energy storage.

With regard to the field of laser chips, important guarantees are provided for normal, efficient and stable operation of the laser chips, so as to prevent degraded or even damaged performance of the chips due to overheating, ensure a uniform temperature of various parts of the chips, ensure consistent output performance thereof, and improve quality and stability of laser output.

With regard to the field of data centers, a temperature of servers is effectively reduced, and heat generated when the data center processing data is taken away through heat exchange, thus guaranteeing stable operation thereof, and improving energy utilization efficiency of the data centers.

With regard to the fields of high-performance computers and artificial intelligence, since scenarios of the high-performance computers, supercomputers, artificial intelligence computations, etc. that require a large amount of complex computations generate extremely high heat, the radiator can satisfy heat dissipation requirements thereof, and ensure full play of computational performance.

With regard to the field of energy storage, battery cell products generate heat during high-power charging and discharging, cooling a battery cell module by the radiator is conducive to maintaining a proper working temperature of a battery cell, prolonging a service life and improving safety.

It is worth noting that, the radiator has important application in fields with high heat dissipation requirements, and with continuous development of technologies and reduction of costs, an application range thereof will be further expanded.

Optionally, each inner-core body 1 includes an inner tube 4 and an outer wall 5, wherein an inner wall of the inner tube 4 is provided with several heat dissipation slots 6, and the outer wall 5 is provided with several slot strips 7.

In the above, the heat dissipation slots 6 are used for dissipating heat during the operation of the laser chip, so as to ensure that the chip can maintain a relatively low temperature when operating.

The slot strips 7 are designed for a purpose that when the inner core and the outer shell 3 are die-casted into one piece, that is, the outer wall is of an upside-down structure, the inner core and the outer shell 3 are connected more tightly. For example, when the laser chip is in some special application scenarios, for example, in the fields of aviation and aerospace, automotive electronics, industrial testing and so on, and an ambient temperature is -40-280 °C, the radiators in the related art are likely to crack, causing that the radiators cannot work normally. The design of the slot strips 7 enables metal structures, even if being deformed in extreme environments, to be buckled with each other, thus ensuring that the inner core is stable in the outer shell 3 and is not likely to crack.

Optionally, a diameter of the inner tube 4 is the same as an internal diameter of the connectors 8 and a diameter of the pipelines 9.

In the present example, the diameter of the inner tube 4 is the same as the internal diameter of the connectors 8 and the diameter of the pipelines 9, thus the coolant can be ensured to flow in the inner core of the radiator, and leakage of the coolant is prevented.

Optionally, a cross section of the heat dissipation slots 6 is any one of following through-hole structures: a peak-tooth shape, a round hole shape, a mesh shape, and a sponge shape.

Certainly, the cross-section of the heat dissipation slots 6 includes, but not limited to, the peak-tooth shape, the round hole shape, the mesh shape, the sponge shape and other through-hole structures.

In the above, the cross section of the heat dissipation slots 6 is of a through-hole structure, and the heat dissipation slots 6 of a through-hole structure can increase a heat dissipation area and dissipate heat in an operation process of the laser chip, so as to ensure that the chip can maintain a relatively low temperature when operating.

Optionally, the several inner-core bodies 1 are of a multi-bend structure.

The several inner-core bodies 1 are of a multi-bend structure, which can increase the heat dissipation area and improve the heat dissipation efficiency. The structurally solid inner core is a reliable cooling circulation system, also referred to as a totally-enclosed cooling circulation system, and through cooperation with the advanced coolant, solves the problems of water electrolysis and microorganism generation of the coolant in an operating condition and oxidation or corrosion of the flow paths in the related art. The radiator of the present invention can be free of maintenance for more than 10 years.

Optionally, the pipelines 9 are fixed on the inner-core bodies 1 by welding.

Optionally, the inner-core bodies 1 are made of a first material, and the outer shell 3 is made of a second material.

In the above, the first material is any one of following high heat conduction materials: copper, silver, diamond, and boron nitride; and the second material is any one of following die-casting materials: aluminum alloy, zinc alloy, and magnesium alloy.

If the inner-core bodies 1 are made of a pure copper material, the outer shell 3 is made of a die-casting aluminum material, in this way, only a core for the coolant to flow is made of the pure copper material, and the outer shell 3 is configured to protect the inner core and thus the outer shell 3 is made of the die-casting aluminum material, which design is reasonable, will not cause material waste, has a high utilization rate, and reduces costs. Meanwhile, the restriction that the whole product can only be processed by a mechanical process can be avoided, and yield and service life of finished products are improved.

Example 5: Referring to FIG. 5, the present invention further discloses a method of manufacturing a radiator, including:
in S3, an inner core of a radiator including inner-core bodies 1 and inner-core fittings 2 was manufactured.

The inner-core bodies 1 and the inner-core fittings 2 are manufactured, and the inner-core bodies and the inner-core fittings are welded into one piece, so as to manufacture the inner core of the radiator.

Referring to FIG. 4, each inner-core body 1 includes an inner tube 4 provided with heat dissipation slots 6 and an outer wall provided with slot strips 7; therefore, a mold of the inner-core bodies 1 is also provided therein with first protrusions matching shapes of the heat dissipation slots 6 and second protrusions matching shapes of the slot strips 7. A drawing process used is simple, and conveniently and quickly forms required shapes. Moreover, taking the inner-core body 1 of pure copper, whose heat conduction coefficient is 401 W/(m•K), as a core component will not cause material waste and reduce production costs.

Optionally, in S3, manufacturing the inner core of the radiator including the inner-core bodies 1 and the inner-core fittings 2 may include following.

In S31, a first material was placed into the mold of the inner-core bodies 1, and a pulling force was applied, to form several inner-core bodies 1 matching a shape of the mold of the inner-core bodies 1. Further, the inner-core bodies 1 were milled, so as to manufacture the inner-core bodies 1.

In the above, the first material may be, for example, copper, a 99.9% pure copper rod is placed into the mold of the inner-core bodies 1, wherein the 99% pure copper rod is grade T2 copper; and a pulling force is applied, wherein a value of the pulling force applied ranges from 15000 N to 22000 N, and the value of the pulling force may be 20000 N. Several inner-core bodies 1 matching the shape of the mold of the inner-core bodies 1 are formed.

In the above, the inner-core bodies 1 are milled, that is, according to a required length of the inner-core bodies 1, an elongated structure via draw forming is cut into several inner-core bodies 1 with a preset length, thus completing manufacturing of the pure copper-made inner-core bodies 1.

In S32, the several inner-core bodies 1 that had been manufactured and the inner-core fittings 2 were welded into one piece.

In the above, the inner-core fittings 2 include several connectors 8 and several pipelines 9, wherein one connector 8 is fixed to an end of a first inner-core body 1 by welding, another connector 8 is fixed to an end of a last inner-core body 1 by welding, and the pipelines 9 connect the plurality of inner-core bodies 1 end to end.

It is worth noting that the radiator is used for flow of a coolant; the inner-core bodies 1 of pure copper can also be referred to as grade T2 copper-made heat dissipation and heat exchange flow paths. The coolant may be an advanced coolant. Thus, the radiator has liquid inlet and outlet, wherein a first connector 8 can serve as a liquid inlet, and the first connector 8 is fixed with an end of a first inner-core body 1 by welding; and a second connector 8 serves as a liquid outlet, and the second connector 8 is fixed with an end of a last inner-core body 1 by welding. Two inner-core bodies 1 are provided between the first inner-core body 1 and the last inner-core body 1, the inner-core bodies 1 communicate with each other through the pipelines 9, and the pipelines 9 are also fixed on the inner-core bodies 1 by welding. The inner core on the whole is of a multi-bend structure, which further increases a heat dissipation area and improves the heat dissipation efficiency. The structurally solid inner core is a reliable cooling circulation system, which can also be referred to as a totally-enclosed cooling circulation system, and through cooperation with the advanced coolant, solves the problems of water electrolysis and microorganism generation of the coolant in an operating condition and oxidation or corrosion of the flow paths in the related art. The radiator of the present invention can be free of maintenance for more than 10 years.

In S33, the inner-core bodies 1 and the inner-core fittings 2 that were welded into one piece were subjected to polishing, cleaning, nickel plating, and drying treatments, so as to manufacture the inner core.

The inner-core bodies 1 and the inner-core fittings 2 that were welded into one piece were subjected to polishing to remove a surface oxide layer; cleaning was performed to remove greasy dirt and impurities on a surface of the inner core, and ensure cleanliness of the surface of the inner core; then the inner-core bodies 1 and the inner-core fittings 2 that were welded into one piece were subjected nickel plating, so as to prevent oxidation and reduce the risk of mutual dissolution of copper and aluminum at a high temperature.

After the nickel plating, the inner-core bodies 1 and the inner-core fittings 2 that were welded into one piece were subjected the drying treatment, so as to evaporate moisture on the surface of the inner core completely, ensure the surface of the inner core to be dry, and avoid problems caused by moisture residues. Thus, the manufacturing of the inner core of the radiator including the inner-core bodies 1 and the inner-core fittings 2 was completed.

Optionally, in S33, subjecting the inner-core bodies and the inner-core fittings that were welded into one piece to polishing, cleaning, nickel plating, and drying treatments may include:
the inner-core bodies and the inner-core fittings that are welded into one piece are subjected to polishing, cleaning with an ultrasonic degreasing agent, rinsing with pure water, surface nickel plating treatment, wind-shear dewatering, and tunnel drying.

The inner-core bodies 1 and the inner-core fittings 2 that are welded into one piece are subjected to polishing, for example, a copper polishing treatment, for removing the surface oxide layer, and the cleaning with an ultrasonic degreasing agent is performed, which can efficiently remove the greasy dirt and impurities on the surface of the inner core, and ensure cleanliness of the surface of the inner core.

Then the inner-core bodies 1 and the inner-core fittings 2 that are welded into one piece are subjected to treatments of rinsing with pure water and surface nickel plating. In the above, the rinsing with pure water can completely clean away residues of the cleaning agent and other impurities, so as to avoid adverse effects on subsequent processes. The surface nickel plating treatment prevents oxidation and reduces the risk of mutual dissolution of copper and aluminum at a high temperature. Then the wind-shear dewatering and tunnel drying are performed, so as to complete the manufacturing of the inner core of the radiator including the inner-core bodies 1 and the inner-core fittings 2. In the above, the wind-shear dewatering can quickly remove moisture from a surface of a workpiece, reduce water stain residues, and facilitate progress of subsequent drying and coating processes. A drying temperature of the tunnel drying may be a preset temperature (e.g., 100 °C), and this drying temperature can be adjusted according to practical requirements, so that the moisture on the surface of the inner core can be quickly evaporated completely to ensure the surface of the inner core to be dry and avoid problems caused by moisture residues.

In S34, foundry sand was filled into the inner core.

By filling the inner core with the foundry sand, a cavity structure can withstand a casting pressure (e.g., 100 Mpa).

In S4, an outer shell 3 of the radiator was manufactured, and a metal composite blank was formed with the inner core and the outer shell 3 being integrated.

In the above, the outer shell of the radiator may be made of a second material. The outer shell 3 of the radiator is manufactured, and the metal composite blank formed by integrating the inner core and the outer shell 3 acts as the radiator, which, for example, may be a copper-aluminum composite blank.

Optionally, in S4, manufacturing the outer shell 3 of the radiator, and integrating the inner core and the outer shell 3 to form the metal composite blank may include:
in S41, a second material liquid was prepared.

In the above, the second material liquid may be an aluminum liquid.

Optionally, in S41, preparing the second material liquid may include:
in S411, the second material was heated and stirred, and a grain refiner was added into the second material in a solution state to form a molten second material; and
in S412, a degassing treatment was performed on the molten second material added with the grain refiner to render the prepared second material liquid.

In the above, the second material may be, for example, aluminum. The second material (e.g., aluminum material) is heated and stirred, and the grain refiner is added into the aluminum material in a solution state to form the molten second material (e.g., molten aluminum).

It is worth noting that type of the aluminum material was A356, a heating temperature was 700-750 °C, which are not particularly limit in the present example.

Next, the degassing treatment was performed on the molten second material added with the grain refiner to render the second material liquid (e.g., aluminum liquid) meeting requirements.

It is worth noting that a weight ratio of the grain refiner to the second material solution may be 0.2:100. The grain refiner mainly functions to improve microstructures of a casting, refine grains, improve mechanical properties and surface quality of the casting, and reduce defects such as shrinkage holes and gas holes. A main effect of the degassing treatment is to remove gases in the second material liquid, reduce generation of the shrinkage holes and gas holes, and improve density and mechanical performance of the casting.

In S42, the manufactured inner core was placed into an anti-gravity cavity mold, the prepared second material liquid was filled into the cavity mold, and a die casting treatment was performed to form a metal composite blank with the first-material outer shell wrapping the second-material inner-core bodies and the inner-core fittings, and the metal composite blank was demolded and naturally cooled to a first temperature.

The manufactured inner core is placed into the anti-gravity cavity mold, the prepared second material solution is filled into the anti-gravity cavity mold, and the die casting treatment is performed to form the metal composite blank (e.g., copper-aluminum-part composite blank) with the first-material outer shell (e.g., aluminum-made outer shell 3) wrapping the second-material (e.g. copper-made) inner-core bodies 1 and the inner-core fittings 2.

Optionally, the die casting treatment is performed at a temperature ranging from 500 °C to 8000 °C and a pressure ranging from 80 MPa to 120 MPa for a time ranging from 150 s to 220 s.

In the present example, a value of the temperature of the die-casting treatment may be 750 °C, a value of the pressure may be 100 MPa, and a value of the time may be 180 s; and alternatively, a value of the temperature of the die-casting treatment may be 800 °C, a value of the pressure may be 120 MPa, and a value of the time may be 220 s.

It is worth noting that a shape of an inner wall of the anti-gravity cavity mold matches a shape of the inner core and a shape of the outer shell, and the second material solution fills gaps of the cavity mold to wrap the inner core.

In S43, the first-material outer shell was trimmed, to remove a material strip and a slag package, and the foundry sand in the inner core was purged and removed.

The material strip and the slag package are removed, that is, the material strip and the slag package are removed by a saw blade cutter. The material strip is tailings formed by a material well in a mold in a die casting process, and in order to ensure parts to be completely filled in a mold, the material well is provided in a position where it is not easy to fill according to a product shape, so that this region is filled with more aluminum liquid so as to achieve a purpose of complete filling. The slag package refers to residues formed in a material package at a feeding port of a mold. The material package is a device for supplying molten metal to a mold in a die casting process, is located in a feeding system of a die-casting machine, and feeds the molten metal into a mold cavity by being connected to the die-casting mold. Moreover, the foundry sand in the inner core of the radiator is purged and removed, that is, the foundry sand in the inner core of the radiator is purged and removed by a high-pressure air rifle.

Optionally, in S31, milling the inner-core bodies may include:
milling the inner-core bodies using a machining process.

For example, the inner-core bodies 1 are milled using a CNC machining process.

In S44, a heat treatment was performed on the first-material outer shell having undergone the die casting treatment.

For example, T4+T6 heat treatments are performed on the first-material outer shell having undergone the die casting treatment.

Optionally, in S44, performing the T4+T6 heat treatments on the first-material outer shell having undergone the die casting treatment may include:
in S441, the first-material outer shell was heated to a solutionizing temperature to make solute atoms in the first-material outer shell to be fused into solvent lattice.

In the above, the outer shell 3 made of the first material can be heated to the solutionizing temperature to make solute atoms in the outer shell 3 to be fused into the solvent lattice. The solute refers to a substance dissolved in an aluminum solvent, and the solvent lattice refers to a crystal structure of a main component in the outer shell 3, wherein atoms are arranged in order to form a lattice structure. The solutionizing treatment may be performed at a temperature of 520 °C for a time of 3 h. This process can improve uniformity and hardness of the outer shell 3, and meanwhile adjust mechanical and chemical properties of alloy. The present example does not particularly limit the temperature or time of the solutionizing.

It is worth noting that in the above T4+T6 heat treatments, a strengthening phase is formed by precipitating solid solute in a solid solution from the alloy, so that the hardness and strength of the alloy are improved, and the hardness of the outer shell 3 can be improved to 95 HV or above. It is worth noting that, when the laser chip is in some special application scenarios, for example, in the fields of aviation and aerospace, automotive electronics, industrial testing and so on, and an ambient temperature is -40-280 °C, the radiators in the related art are likely to crack, causing that the radiators cannot work normally, while the radiator in the present invention can maintain high dimensional stability, thermal shock resistance and high temperature and humidity resistance in an extreme environment of -40-280 °C.

In S442, the first-material outer shell having undergone the solutionizing treatment was subjected to a water-quenching treatment.

The outer shell 3 having undergone the solutionizing treatment is subjected to the water-quenching treatment, that is, the first-material outer shell having undergone the solutionizing treatment is rapidly cooled, so that the outer shell 3 is rapidly cooled to a preset temperature, for example, 20-35 °C, so as to prevent precipitation of the solute from the solid solution as far as possible. The present example does not particularly limit the preset temperature.

In S443, the first-material outer shell having undergone the water-quenching treatment was continuously heated at a second temperature for a preset duration.

The rapidly cooled outer shell 3 is continuously heated at the second temperature for the preset duration, so as to enhance hardness and strength of the alloy. In the above, the second temperature may be, for example, 180 °C, and the preset duration may be, for example, 3 h. The present example does not particularly limit the second temperature or the preset duration.

In S444, the heated first-material outer shell was left to stand at a third temperature.

The heated outer shell 3 is left to stand at the third temperature, so that the solute inside the solid solution of the outer shell 3 is gradually diffused and precipitated to form a desired strengthening phase, thereby further improving the hardness and strength of the outer shell 3. In the above, the third temperature may be, for example, 20-35 °C. The present example does not particularly limit the third temperature.

In S45, the first-material outer shell having undergone the heat treatments was subjected to roughing.

For example, the first-material outer shell having undergone the heat treatments is subjected to CNC roughing, so as to finely process the surface, and ensure accuracy of sizes and shapes of the inner-core bodies 1 and the outer shell 3. The CNC machining proceeds automatically, thus greatly improving the production efficiency and reducing the time and costs of manual operation. The CNC machining can maintain stable machining quality in the production, and reduce errors caused by human factors.

Optionally, in S45, roughing the first-material outer shell having undergone the heat treatments may include:
milling the first-material outer shell having undergone the heat treatments.

The outer shell 3 having undergone the heat treatments is subjected to CNC cutting by utilizing process positioning hole building reference, so as to process out an XYZ reference, and facilitate fine positioning and fine processing in post processes.

In S46, the integrated metal composite blank having undergone the roughing was cleaned and dried.

The integrated metal composite blank having undergone the roughing is cleaned and dried, wherein cleaning with an ultrasonic degreasing agent can be performed on the metal composite blank, which can efficiently remove greasy dirt and impurities on a surface of the outer shell 3, and ensure cleanliness of the surface of the outer shell 3; then rinsing with pure water is performed; next wind-shear dewatering is performed, which can quickly remove moisture from a surface of a workpiece, reduce water stain residues, and facilitate progress of subsequent drying and coating processes; and finally tunnel drying is performed, wherein a drying temperature is 100 °C at the highest, which can quickly evaporate the moisture on the surface of the outer shell 3 completely to ensure the surface of the outer shell 3 to be dry and avoid problems caused by moisture residues. The rinsing with pure water can completely clean away residues of the cleaning agent and other impurities, thus avoiding adverse effects on subsequent processes.

The above-mentioned examples are merely several embodiments of the present invention, of which the description is relatively specific and detailed, but they should not be thus construed as limitation to the patent scope of the present invention. It is to be noted that, those ordinarily skilled in the art could further make various modifications and improvements without departing from the concept of the present invention, and all of these fall within the scope of protection of the present invention. Therefore, the scope of protection of the present application for patent should be determined by the enclosed claims.

### INDUSTRIAL APPLICABILITY

For the composite radiator manufactured by the integrated aluminum-copper die-casting process for a laser chip provided in the present invention, first, the inner core of the radiator with the copper-made inner-core bodies and the inner-core fittings is manufactured, then in the method of manufacturing the aluminum-made outer shell, the inner core is stably provided in the outer shell by means of die casting and T4+T6 heat treatments, the inner core with the copper-made inner-core bodies and the aluminum-made outer shell are bonded to form the copper-aluminum-part composite, which has better strength and wear resistance, improves overall use performance of the radiator, and enables the radiator to maintain high dimensional stability, thermal shock resistance and high temperature and humidity resistance in the extreme environment of -40-280 °C; moreover, the radiator is not simply machined, so that the radiator is not vulnerable to cracking or deformation; besides, the surfaces of the inner core and the outer shell of the radiator are respectively subjected to surface finishing, thus ensuring the heat dissipation effect of the radiator; furthermore, the inner-core bodies of the radiator are made of the pure copper material, and the outer shell of the radiator is made of the die-casting aluminum material, so that areas are dedicated for special uses, material waste is avoided, and the costs are saved; the design of the heat dissipation slots of the inner-core bodies increases the heat dissipation area, and improves the heat dissipation efficiency; the design of the slot strips on the outer walls of the inner-core bodies ensures that the connection between the inner core and the outer shell of the radiator is more stable, the structural size stability is strong, the service life is prolonged, and the maintenance cost is reduced.

## Claims

1. A method of manufacturing an aluminum-copper integrated die-casting composite radiator for a laser chip, **characterized by** comprising following steps:
in S1, manufacturing an inner core of a radiator comprising inner-core bodies and inner-core fittings, comprising:
in S11, placing a copper rod into a mold of the inner-core bodies, applying a pulling force to form several inner-core bodies matching a shape of the mold of the inner-core bodies, further milling the inner-core bodies, thus completing manufacturing of the inner-core bodies made of pure copper;
in S12, welding the several inner-core bodies that have been manufactured and the inner-core fittings into one piece;
in S13, subjecting the inner-core bodies and the inner-core fittings welded into one piece to copper polishing, cleaning, nickel plating, and drying treatments, thus completing manufacturing of the inner core of the radiator comprising the inner-core bodies and the inner-core fittings; and
in S14, filling foundry sand into the inner core; and
in S2, manufacturing an outer shell of the radiator, and forming a copper-aluminum composite blank with the inner core and the outer shell being integrated, comprising:
in S21, preparing an aluminum liquid;
in S22, placing the manufactured inner core into an anti-gravity cavity mold, filling the prepared aluminum liquid into the cavity mold, performing a die casting treatment to form a copper-aluminum-part composite blank with the aluminum-made outer shell wrapping the copper-made inner-core bodies and the inner-core fittings, and demolding and naturally cooling to 20-35 °C;
in S23, trimming the outer shell, to remove a material strip and a slag package, and purging and removing the foundry sand in the inner core of the radiator;
in S24, performing T4+T6 heat treatments on the outer shell having undergone the die casting treatment;
in S25, subjecting the outer shell having undergone the heat treatments to CNC roughing; and
in S26, cleaning and drying the integrated copper-aluminum composite blank having been roughed.

2. The method of manufacturing an aluminum-copper integrated die-casting composite radiator for a laser chip according to claim 1, wherein performing T4+T6 heat treatments on the outer shell having undergone the die casting treatment in the step S24 comprises following substeps:
S241, solutionizing treatment: heating the outer shell to a solutionizing temperature to make solute atoms in the outer shell to be fused into solvent lattice, wherein the solutionizing treatment is performed at a temperature of 470 °C-540 °C for a time of 2 h-3 h;
S242, rapid cooling treatment: subjecting the outer shell having undergone the solutionizing treatment to a water-quenching treatment, to rapidly cool the outer shell to 20 °C-35 °C;
S243, aging treatment: continuously heating the rapidly cooled outer shell at a temperature of 120 °C-200 °C for a time of 2 h-3 h; and
S244, natural cooling treatment: leaving the outer shell having undergone the aging treatment to stand at 20 °C-35 °C.

3. The method of manufacturing an aluminum-copper integrated die-casting composite radiator for a laser chip according to claim 1 or 2, wherein preparing an aluminum liquid in the step S21 comprises following substeps:
S211, heating and stirring an aluminum material, and adding a grain refiner into the aluminum material in a solution state to form molten aluminum; and
S212, further performing a degassing treatment on the molten aluminum added with the grain refiner to render the prepared aluminum liquid.

4. The method of manufacturing an aluminum-copper integrated die-casting composite radiator for a laser chip according to any one of claims 1-3, wherein subjecting the inner-core bodies and the inner-core fittings welded into one piece to copper polishing, cleaning, nickel plating, and drying treatments in the step S13 comprises: performing the copper polishing to remove an oxide layer, cleaning with an ultrasonic degreasing agent, rinsing with pure water, then performing surface nickel plating treatment, next performing wind-shear dewatering, and then performing tunnel drying, wherein a drying temperature is 100 °C at the highest; and the cleaning and drying the integrated copper-aluminum composite blank in the step S26 comprises: cleaning with an ultrasonic degreasing agent, then rinsing with pure water, next performing wind-shear dewatering, and then performing tunnel drying, wherein a drying temperature is 100 °C at the highest.

5. The method of manufacturing an aluminum-copper integrated die-casting composite radiator for a laser chip according to any one of claims 1-4, wherein for milling the inner-core bodies in the step S11, the inner-core bodies are milled using a CNC machining process; and subjecting the outer shell having undergone the heat treatments to CNC roughing in the step S25 is cutting the outer shell.

6. The method of manufacturing an aluminum-copper integrated die-casting composite radiator for a laser chip according to claim 3, wherein in preparing the aluminum liquid in the step S21, a weight ratio of the grain refiner to the aluminum liquid is 0.2:100.

7. The method of manufacturing an aluminum-copper integrated die-casting composite radiator for a laser chip according to any one of claims 1-6, wherein in die-casting solidification shrinkage in the step S22, the die casting treatment is performed at a temperature of 500 °C-800 °C and a pressure of 80 MPa-120 MPa for a time of 150 s-220 s.

8. The method of manufacturing an aluminum-copper integrated die-casting composite radiator for a laser chip according to any one of claims 1-7, wherein for the pulling force applied in the step S11, a value of the pulling force is 15000 N-22000 N.

9. An aluminum-copper integrated die-casting composite radiator for a laser chip, **characterized in that** the aluminum-copper integrated die-casting composite radiator for a laser chip is manufactured by the method of manufacturing an aluminum-copper integrated die-casting composite radiator for a laser chip according to any one of claims 1-8, and comprises: several inner-core bodies, inner-core fittings and an outer shell, wherein the inner core fittings comprise several connectors and several pipelines, one of the connectors is fixed to an end of a first one of the inner-core bodies by welding, another one of the connectors is fixed to an end of a last one of the inner-core bodies by welding, the pipelines connect the several inner-core bodies end to end, and the outer shell wraps the inner-core bodies and the inner-core fittings that are welded into one piece.

10. The aluminum-copper integrated die-casting composite radiator for a laser chip according to claim 9, wherein the inner-core bodies each comprise an inner tube provided with several heat dissipation slots on an inner wall; and an outer wall provided with several slot strips, wherein a diameter of the inner tube is the same as an internal diameter of the connectors and a diameter of the pipelines, and a cross section of the heat dissipation slots is in a peak-tooth shape.

11. A radiator, comprising several inner-core bodies, inner-core fittings and an outer shell, **characterized in that** the inner-core fittings comprise several connectors and several pipelines, one of the connectors is fixed to an end of a first one of the inner-core bodies by welding, another one of the connectors is fixed to an end of a last one of the inner-core bodies by welding, the pipelines connect the plurality of inner-core bodies end to end, and the outer shell wraps the inner-core bodies and the inner-core fittings that are welded into one piece; and the inner-core bodies are bonded by any one of welding bonding, mechanical bonding, metallurgical bonding or other types of bonding.

12. The radiator according to claim 11, wherein the inner-core bodies each comprise an inner tube provided with several heat dissipation slots on an inner wall; and an outer wall provided with several slot strips; a diameter of the inner tube is the same as an internal diameter of the connectors and a diameter of the pipelines; and a cross section of the heat dissipation slots is any one of following through-hole structures: a peak-tooth shape, a round hole shape, a mesh shape, and a sponge shape.

13. The radiator according to any one of claims 11-12, wherein the inner-core bodies are made of a first material, and the outer shell is made of a second material.

14. The radiator according to any one of claims 11-12, wherein the first material is any one of following high heat conduction materials: copper, silver, diamond, and boron nitride; and the second material is any one of following die-casting materials: aluminum alloy, zinc alloy, and magnesium alloy.

15. The radiator according to any one of claims 11-14, wherein the radiator is at least applied to following fields: laser chips, data centers, high-performance computers, artificial intelligence, and energy storage.

16. A method of manufacturing a radiator, **characterized by** comprising steps of:
manufacturing an inner core of a radiator comprising inner-core bodies and inner-core fittings; and
manufacturing an outer shell of the radiator, and forming a metal composite blank with the inner core and the outer shell being integrated.

17. The method of manufacturing a radiator according to claim 16, wherein the step of manufacturing an inner core of a radiator comprising inner-core bodies and inner-core fittings comprises:
placing a first material into a mold of the inner-core bodies; applying a pulling force, to form several inner-core bodies matching a shape of the mold of the inner-core bodies; and milling the inner-core bodies, so as to manufacture the inner-core bodies;
welding the several inner-core bodies that have been manufactured and the inner-core fittings into one piece;
subjecting the inner-core bodies and the inner-core fittings that are welded into one piece to polishing, cleaning, nickel plating, and drying treatments, so as to manufacture the inner core; and
filling foundry sand into the inner core; and
the step of manufacturing an outer shell of the radiator, and forming a metal composite blank with the inner core and the outer shell being integrated comprises:
preparing a second material liquid;
placing the manufactured inner core into an anti-gravity cavity mold, filling the prepared second material liquid into the anti-gravity cavity mold, and performing a die casting treatment to form a metal composite blank with the first-material outer shell wrapping the second-material inner-core bodies and the inner-core fittings, and demolding and naturally cooling to a first temperature;
trimming the first-material outer shell, to remove a material strip and a slag package, and purging and removing the foundry sand in the inner core;
performing a heat treatment on the first-material outer shell having undergone the die casting treatment;
subjecting the first-material outer shell having undergone the heat treatments to roughing; and
cleaning and drying the integrated metal composite blank having undergone the roughing.

18. The method of manufacturing a radiator according to claim 17, wherein the step of performing a heat treatment on the first-material outer shell having undergone the die casting treatment comprises:
heating the first-material outer shell to a solutionizing temperature to make solute atoms in the first-material outer shell to be fused into solvent lattice;
subjecting the first-material outer shell having undergone the solutionizing treatment to a water-quenching treatment;
continuously heating the first-material outer shell having undergone the water-quenching treatment at a second temperature for a preset duration; and
leaving the heated first-material outer shell to stand at a third temperature.

19. The method of manufacturing a radiator according to claim 17, wherein the step of preparing a second material liquid comprises:
heating and stirring the second material, and adding a grain refiner into the second material in a solution state to form a molten second material; and
performing a degassing treatment on the molten second material added with the grain refiner to render the prepared second material liquid.

20. The method of manufacturing a radiator according to claim 17, wherein the step of subjecting the inner-core bodies and the inner-core fittings that are welded into one piece to polishing, cleaning, nickel plating, and drying treatments comprises:
subjecting the inner-core bodies and the inner-core fittings that are welded into one piece to polishing, cleaning with an ultrasonic degreasing agent, rinsing with pure water, surface nickel plating treatment, wind-shear dewatering, and tunnel drying in sequence; and
the step of cleaning and drying the integrated metal composite blank having undergone the roughing comprises:
subjecting the integrated metal composite blank having undergone the roughing to cleaning with an ultrasonic degreasing agent, rinsing with pure water, wind-shear dewatering, and tunnel drying.
